# EUROPEAN PATENT SPECIFICATION

(11) **EP 2 831 707 B1**
(45) Date of publication and mention of the grant of the patent: **14.03.2018**
(21) Application number: 12711407.2
(22) Date of filing: 30.03.2012
(51) Int. Cl.: G06F 3/041

(54) **TRANSPARENT BODY FOR USE IN A TOUCH SCREEN PANEL MANUFACTURING METHOD AND SYSTEM**
DURCHSICHTIGER KÖRPER ZUR VERWENDUNG IN EINEM BERÜHRUNGSBILDSCHIRM-HERSTELLUNGSVERFAHREN UND -SYSTEM
CORPS TRANSPARENT DESTINÉ À ÊTRE UTILISÉ DANS UN PROCÉDÉ DE FABRICATION DE PANNEAU D'ÉCRAN TACTILE ET SYSTÈME

(43) Date of publication of application: 04.02.2015
(73) Proprietor: Applied Materials, Inc., Santa Clara, CA 95054 (US)
(72) Inventor: ZILBAUER, Thomas Werner, 63755 Alzenau (DE); GRILLMAYER, Jürgen, 600 Chiayi City (TW)
(74) Representative: Zimmermann & Partner Patentanwälte mbB
(86) International application number: PCT/EP2012/055867
(87) International publication number: WO 2013/143614

(56) References cited:
- EP-A1- 1 574 882
- EP-A1- 1 892 609
- EP-A1- 2 402 481
- EP-A2- 1 947 551
- JP-A- 2011 129 165
- US-A1- 2008 152 879
- US-A1- 2012 057 237

## Description

### TECHNICAL FIELD

Embodiments of the present disclosure relate to processes and systems for manufacturing a transparent body for use in a touch screen panel and a transparent body fabricated according to these processes.

### BACKGROUND ART

Touch panels or touch screen panels are a particular class of electronic visual displays, which are able to detect and locate a touch within a display area. Generally, touch panels include a transparent body disposed over a screen and configured to sense a touch. Such a body is substantially transparent, so that light in the visible spectrum emitted by the screen can be transmitted therethrough. At least some known touch panels include a transparent body constituted by a barrier and a transparent conductor formed, in this order, over a substrate. A touch on the display area of such a panel generally results in a measurable change of capacitance in a region of the transparent body. The change in capacitance may be measured using different technologies, so that the position of the touch can be determined.

A transparent body for use with a touch panel is subject to some particular requirements. In particular, one key requirement is that the transparent body is stable enough for withstanding multiple contacts on the screen and harsh conditions, so that reliability of the touch screen is not compromised over time. However, at least some known transparent bodies included in touch screens and considered robust interfere with a proper transmission of light therethrough due to, for example, thickness, composition, and structure of the layers forming the transparent body. Furthermore, fabricating such a stable transparent body with high quality, for example with a uniform and defect-free barrier, is challenging.

Further, it is to be considered that there are different types of transparent bodies for touch panels. Particular consideration of the optical characteristics, e.g. the appearance to a user, has to be taken into account for transparent bodies, wherein the conductive layer for measuring the change in capacitance is a structured conductive layer.

A further aspect to be considered is the steadily increasing size of displays, wherein beyond the optical characteristics described above, also electrically characteristics are of increasing interest. Thereby, a design of thin film based flat panel displays and touch screen technologies, which provides an invisible object, which is patterned with respect to conductivity (like a touch sensor structure) and which exhibits enhanced optical and electrical performance compared to conventional structures, is desired.

Accordingly, it is desirable a process and an apparatus for forming a high-quality transparent body for use in a touch panel in a manner such that the body is stably formed over the substrate without compromising a proper transmission of light in the visible spectrum and improved electrical characteristics.

EP 2 402 481 A1, US 2012/057237 A1, EP 1 574 882 A1 and EP 1 892 609 A1 all describe methods of manufacturing touch screen panels.

### SUMMARY OF THE INVENTION

In light of the above, the invention provides a process according to independent claim 1, a transparent body according to independent claim 6, and an apparatus according to independent claim 13. Further aspects, advantages, and features of the present invention are apparent from the dependent claims, the description, and the accompanying drawings.

According to one embodiment, a process for manufacturing a transparent body for use in a touch screen panel or display panel is provided. The process includes depositing a first transparent layer stack over a transparent substrate, wherein said first transparent layer stack includes at least a first dielectric film with a first refractive index and a second dielectric film with a second refractive index different from the first refractive index, providing a structured transparent conductive film, and wherein the structured transparent conductive film corresponds to a sheet resistance of 100 Ohm/square or below, and providing a transparent adhesive over the structured transparent conductive film configured for attaching the layer stack to the adjacent component of the touch screen panel or display panel. According to an alternative embodiment, the first transparent layer stack can alternatively to the above-mentioned first transparent layer stack be a first transparent layer stack including a first dielectric film with a gradient refractive index from a first refractive index to a second refractive index.

According to another embodiment, a transparent body adapted for use in a touch screen panel or display panel is provided. The transparent body includes a transparent substrate, a transparent layer stack deposited over the transparent substrate, wherein said transparent layer stack includes at least a first dielectric film with a first refractive index, and a second dielectric film with a second refractive index different from the second the first refractive index, a transparent conductive film deposited over the transparent substrate, wherein the structured transparent conductive film corresponds to a sheet resistance of 100 Ohm/square or below, and a transparent adhesive deposited over the transparent conductive film and being configured for attaching the transparent body to the adjacent component of the touch screen panel or display. According to an alternative embodiment, the transparent layer stack can alternatively to the above-mentioned transparent layer stack be a transparent layer stack including a first dielectric film with a gradient refractive index from a first refractive index to a second refractive index.

According to another embodiment, a deposition apparatus for manufacturing a transparent body for use in a touch panel is provided. The apparatus includes: a first deposition assembly configured to deposit a first transparent layer stack over a substrate, said first transparent layer stack including at least first dielectric film with a first refractive index, and a second dielectric film with a second refractive index different from the first refractive index, and a second deposition assembly configured to deposit a transparent conductive film, wherein at least one of the first deposition assembly or the second deposition assembly comprises a sputtering system operatively coupled to a target, said sputtering system being configured to deposit at least one of the first dielectric film, the second dielectric film, or the transparent conductive film by sputtering of the target.

Surprisingly, the combination of dielectric films deposited according to embodiments of the present disclosure having additional dielectric films in comparison to at least some known transparent bodies for use in a touch panel, with a characteristic combination of refractive indexes in combination with a transparent adhesive, and in which at least one of the films is deposited by sputtering of a target, facilitates manufacturing of a high-quality transparent body that not only yields proper transmission of light but also yields stable performance over time. Yet further, as compared to existing "invisible" transparent bodies for touch panels, the resistance can be reduced, which is, for example, useful for large area touch panels.

Embodiments are also directed to apparatuses for carrying out the disclosed processes and including apparatus parts for performing described process steps. Furthermore, embodiments are also directed to methods by which the described apparatus operates or by which the described apparatus is manufactured. The methods may include method steps for carrying out functions of the apparatus or manufacturing parts of the apparatus. The method steps may be performed by way of hardware components, firmware, software, a computer programmed by appropriate software, by any combination thereof or in any other manner.

### BRIEF DESCRIPTION OF THE DRAWINGS

A full and enabling disclosure, including the best mode thereof, to one of ordinary skill in the art, is set forth more particularly in the remainder of the specification, including reference to the accompanying figures, wherein:
Fig. 1A is a schematic representation of an exemplary transparent body for use in a touch panel in accordance with embodiments herein;
Fig. 1B is a schematic representation of an exemplary transparent body for use in a touch panel in accordance with embodiments herein;
Fig. 2A is a schematic representation of a further exemplary transparent body for use in a touch panel and an opto-electronic device to which the body is bonded in accordance with embodiments herein;
Fig. 2B is a schematic representation of a further exemplary transparent body for use in a touch panel and an opto-electronic device to which the body is bonded in accordance with embodiments herein;
Figs. 3A to 3D are schematic representation of the manufacturing of an exemplary transparent body for use in a touch panel in accordance with embodiments herein;
Figs. 4, 5A and 5B are schematic representations of yet further exemplary transparent bodies for use in a touch panel in accordance with embodiments herein;
Fig. 6 is a schematic representation of a portion of an apparatus for depositing an exemplary transparent body for use in a touch panel in accordance with embodiments herein; and
Fig. 7 is a flow chart illustrating methods of manufacturing a transparent body for use in a touch panel in accordance with embodiments herein.

### DETAILED DESCRIPTION OF THE INVENTION

Reference will now be made in detail to the various embodiments, one or more examples of which are illustrated in the figures. Each example is provided by way of explanation, and is not meant as a limitation of the invention. It is contemplated that elements of one embodiment may be advantageously utilized in other embodiments without further recitation.

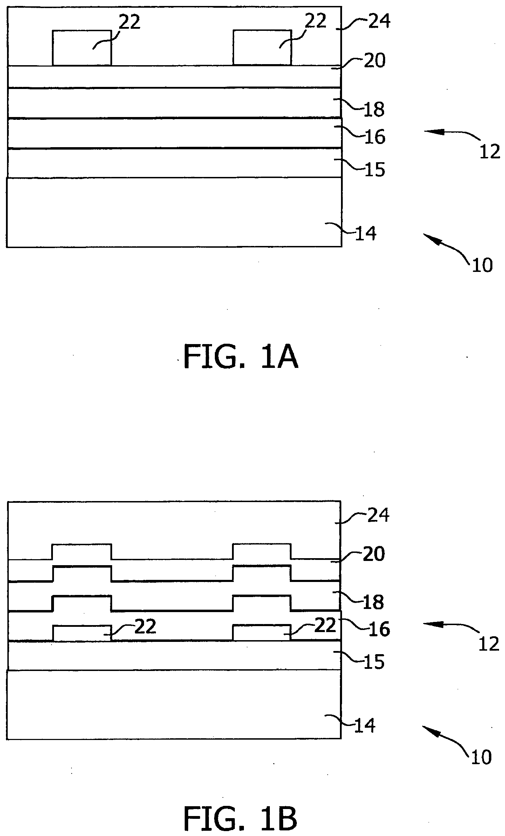

According to embodiments herein, a first transparent layer stack 12, as depicted in FIG. 1A, is deposited over a substrate 14. The term "substrate" as used herein shall embrace both inflexible substrates, e.g., a wafer, slices of transparent crystal such as sapphire or the like, or a glass plate, and flexible substrates such as a web or a foil. The term "transparent" as used herein shall particularly include the capability of a structure to transmit light with relatively low scattering, so that, for example, light transmitted therethrough can be seen in a substantially clearly manner. In the case of a flexible substrate, it is typical that substrate 14 has a hard coat 15 formed thereon.

According to typical embodiments, a layer stack is constituted by a number of films formed (e.g., by deposition) one atop of another. In particular, embodiments herein include depositing a first transparent layer stack which may be constituted by a plurality of dielectric films, that is, films that, substantially, do not conduct electricity. In particular, first transparent layer stack 12 may include a first dielectric film 16, a second dielectric film 18, and a third dielectric film 20, as exemplarily depicted in FIG. 1A. Thereby, the first transparent layer stack may constitute a barrier for use in a touch panel.

As shown in FIG. 1A, a structured transparent conductive oxide (TCO) film 22 is provided over the transparent layer stack. According to typical embodiments, the structured TCO layer can be provided by depositing a TCO layer and patterning the TCO layer in order to provide a structured TCO layer. Alternatively, a mask and/or a photoresist can be provided to deposit the structured TCO layer.

According to typical embodiments, which can be combined with other embodiments described herein, the transparent conductive oxide layer can be an indium tin oxide (ITO) layer, a doped ITO layer, impurity-doped ZnO, In₂O₃, SnO₂ and CdO, ITO (In2O3:Sn), AZO (ZnO:Al), IZO (ZnO: In), GZO (ZnO:Ga), multi-component oxides including or consisting of combinations of ZnO, In₂O₃ and SnO₂, a layer stack from at least an ITO layer and a metal layer, e.g. an ITO/metal/ITO-stack or a metal/ITO/metal-stack.

Conventional layer stacks or transparent bodies for touch panels can result in a functional screen (like a touch screen). However, an inferior sunlight readability, a colored appearance (reflectance) of the screen and a color change with respect to the produced picture from the underlying display, and a more or less visible pattern from the structured core layer of the functional screen (e.g. a patterned transparent conductive oxide, TCO) is often obtained. Further, the conductivity might not be sufficient for large area touch panels, e.g. touch panels with a diagonal of 7 inch or above, specifically for touch screens with a diagonal of more than 20 inch.

Due to the structure of the transparent layer stack, it is facilitated that the conductive film does not prejudice an optimal transmission of light through the body. In particular, a transparent layer stack according to embodiments herein facilitates that a conductive film, even a structured conductive film, does not affect the neutrality of the reflectance color, as further discussed below.

According to typical embodiments, which can be combined with other embodiments described herein, the sheet resistance of the structured TCO layer is 100 Ohm/sq and below, e.g. 10 to 50 Ohm/sq. Typically, the sheet resistance is the physical quantity referred to in this context, even though this value refers to the resistance of a layer with a sufficiently large area, i.e. without too small patterns. The structured TCO pattern, e.g. lines, corresponds to a line resistance in Ohm. However, the sheet resistance is the relevant parameter and can be determined by deposition of test areas or can be determined or calculated based upon the resistance of patterned structures and the structure geometry. Accordingly, even though the sheet resistance of the structure layer cannot be directly determined (yet indirectly) and rather refers to the resistance of an unstructured layer, a person skilled in the art would relate to a sheet resistance corresponding to a value for the structured layer.

According to different embodiments, the TCO films, e.g. ITO, can be deposited at relatively high temperatures or alternatively at lower temperatures, wherein in the latter case an annealing step after deposition can be provided in order to achieve desired layer characteristics such as the sheet resistance.

Thereby, for example, TCO layer thicknesses of 20 nm or above, of 30 nm or above, of 40 nm or above, e.g. 50 nm to 150 nm can be utilized. Additionally or alternatively, transparent conductive oxides with a specific resistance lower than the typical resistivity range of ITO produced with various process schemes, which is 130-450 µΩcm for bulk ITO, i.e. superior electrical characteristics, but with inferior optical characteristics could be used. The reduced sheet resistance and/or the increased TCO layer thickness results in the desire for further improvement of the layer stack or transparent body, as the, e.g. thicker, structured TCO layer tends to be more easily visible.

According to embodiments described herein, an enhanced structure and method of manufacturing such an invisible object, e.g. a touch sensor, are provided to surpass limitations to the patterned TCO thickness and its conductivity. Layer stacks or transparent bodies as described herein, which are provided on a display, or the like are considered invisible when placed in an atmosphere of air (refractive index 1) with very little difference in the optical appearance between areas with and without the TCO layer, such as ITO ("invisible" ITO). According to some embodiments, which can be combined with other embodiments described herein, different stacks and mounting scheme for an invisible object, e.g. for being integrated into or mounted onto a display, is provided in such a way that at least on one side of the object the adjacent medium has a refractive index being different than 1, e.g. 1.3 to 1.7. By this means, the invisible stack can support a sheet resistance of 20 Ohm/sq or below, which is an improvement by a factor of 10 compared to the previous concepts without compromising on optical performance.

As shown in FIG. 1A a transparent adhesive 24 is provided over the TCO layer 22. According to typical, optional implementation, the transparent adhesive can be an optical clear adhesive laminate or liquid optical clear adhesive with a refractive index of 1.3 to 1.7, e.g. a refraction index close to the refractive index of glass (1.48) or PMMA (1.6), hence, as a further example, in the range between 1.48 and 1.6. According to yet further embodiments, which can be combined with other embodiments described herein, the transparent adhesive 24 can have a visual transmittance of 95 % or above, 97 % or above, or even 99% or above, and can have a low haze, e.g. of 3 % or below, 2 % or below, or even 1 % or below.

According to typical embodiments, which can be combined with other embodiments described herein, the transparent adhesive can be configured for attaching the layer stack or transparent body to the adjacent components of the touch panel or display panel, e.g. any of the opto-electronic devices (touch screens, touch panels, displays, display panels, etc) for which the transparent body can be utilized.

As compared to previous designs of touch panel displays where, particularly for layer stacks or transparent bodies with thicker TCO layers, an air gap has been provided, embodiments described herein provide a layer stack or transparent body having at least a index matching layer stack, e.g. one or more dielectric films, a TCO layer over the index matching layer stack, wherein the TCO layer has a sheet resistance of 100 Ohm/sq or below, and a transparent adhesive provided onto the TCO layer, i.e. in contact with the TCO layer. The embodiments thereby provide an "invisible" touch panel structure, which also provides for a low resistance. The optical bonding for obtaining a solution to low-resistance "invisible" TCO patterns refer to a structure having a TCO layer on top before this structure is bonded, e.g. optically bonded, onto the adjacent components of a touch screen display with a transparent adhesive. By utilizing the transparent adhesive, a final pattern "invisibility" of the TCO pattern can be achieved.

According to embodiments herein, a structured transparent conductive oxide film 22, as depicted in FIG. 1B, is deposited over a substrate 14. In the case of a flexible substrate, it is typical that substrate 14 has a hard coat 24 formed thereon. According to typical embodiments, the structured TCO layer can be provided by depositing a TCO layer and patterning the TCO layer in order to provide a structured TCO layer. Alternatively, a mask and/or a photoresist can be provided to deposit the structured TCO layer.

According to typical embodiments, which can be combined with other embodiments described herein, the transparent conductive oxide layer can be an indium tin oxide (ITO) layer, a doped ITO layer, impurity-doped ZnO, In₂O₃, SnO₂ and CdO, ITO (In2O3:Sn), AZO (ZnO:Al), IZO (ZnO: In), GZO (ZnO:Ga), multi-component oxides including or consisting of combinations of ZnO, In₂O₃ and SnO₂, a layer stack from at least an ITO layer and a metal layer, e.g. an ITO/metal/ITO-stack or a metal/ITO/metal-stack.

A layer stack, such as an index matching layer stack is provided over the TCO film 22. According to typical embodiments, a layer stack is constituted by a number of films formed (e.g., by deposition) one atop of another. In particular, embodiments herein include depositing a first transparent layer stack which may be constituted by a plurality of dielectric films, that is, films that, substantially, do not conduct electricity. In particular, first transparent layer stack 12 may include a first dielectric film 16, a second dielectric film 18, and a third dielectric film 20, as exemplarily depicted in FIG. 1B and described in more detail with respect to FIG. 1A. Thereby, the first transparent layer stack may constitute a passivation for the structured TCO film for use in a touch panel.

As shown in FIG. 1B a transparent adhesive 24 is provided over the transparent layer stack 12. According to typical, optional implementation, the transparent adhesive can be an optical clear adhesive laminate or liquid optical clear adhesive with a refractive index of 1.3 to 1.7, e.g. a refraction index close to the refractive index of glass (1.48) or PMMA (1.6), hence, as a further example, in the range between 1.48 and 1.6. According to yet further embodiments, which can be combined with other embodiments described herein, the transparent adhesive 24 can have a visual transmittance of 95 % or above, 97 % or above, or even 99% or above, and can have a low haze , e.g. of 3 % or below, 2 % or below, or even 1 % or below.

According to yet further embodiments, the structured TCO film and the dielectric films can be provided similarly as described with respect to FIG. 1A above. According to embodiments described herein, both, the transparent layer stack and the structured transparent conductive film, are provided over the substrate and between the substrate and the transparent adhesive. Yet, the order of the index-matching stack and the transparent conductive film can be switched. However, according to a typical embodiment, the transparent conductive film is provided on the substrate or the substrate coated with a hard coat or the like, i.e. without the dielectric films, as this might simplify structuring of the transparent conductive film.

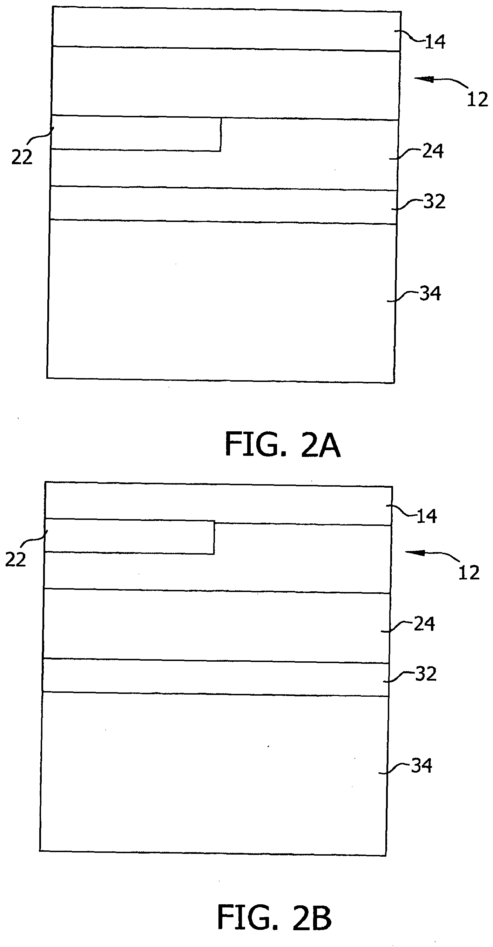

As shown in FIG. 2A, a transparent adhesive 24 is provided to bond the touch panel layer stack having, e.g., a substrate 14, a layer stack 12 and a structured TCO layer 22 to a display. In FIG. 2A, the display is exemplarily indicated by a color filter 32 and a pixel array or display 34. Thereby, the transparent body 10 is shown inverted as compared to FIG. 1A. Accordingly, the substrate 14 can be, for example, a cover lens of a touch panel display. The term cover lens is typically used as a topmost glass of a touch panel. According to yet further embodiments, which can be combined with other embodiments described herein, the transparent body 10 can be bonded with the transparent adhesive, for example an OCA (optical clear adhesive), to a color filter glass, to a polarizer of a display structure, or to a liquid crystal display structure itself.

As shown in FIG. 2B, a transparent adhesive 24 is provided to bond the touch panel layer stack having, e.g., a substrate 14, a structured TCO layer 22, and a layer stack 12 to a display. In FIG. 2B, the display is exemplarily indicated by a color filter 32 and a pixel array or display 34. Thereby, the transparent body 10 is shown inverted as compared to FIGS. 1A and 1B. Accordingly, the substrate 14 can be, for example, a cover lens of a touch panel display. The term cover lens is typically used as a topmost glass of a touch panel. According to yet further embodiments, which can be combined with other embodiments described herein, the transparent body 10 can be bonded with the transparent adhesive, for example an OCA (optical clear adhesive), to a color filter glass, to a polarizer of a display structure, or to a liquid crystal display structure itself.

Embodiments according to the present invention relate to a layer stack or transparent body comprising of a substrate, e.g. a cover glass, and a stack of multiple layers that is mounted on top of a display with a clear adhesive, i.e. without an air gap. The layer stack comprises transparent, insulating materials with high and low refractive indexes (such as SiOx, TiOx, NbOx, SiNx, SiOxNy, AlOx, AlOxNy, MgF2, and TaOx) and transparent conductive materials, like transparent conductive oxides, for example ITO. According to implementations, the method of layer coating or layer deposition can be chemical or physical vapor deposition.

According to different examples, a layer stack or transparent body can be manufactured as follows, wherein improved visual invisibility, transmittance and color fastness within the final TSP (touch screen panel)/display product and reduced electrical resistance can be provided. The layers are numbered as they are subsequently deposited on a substrate, e.g. a cover lens such as a glass having a thickness of 0.1 mm or above, e.g. 0.5 mm to 0.7 mm or of about 0.3 mm. Layer 1: SiOx of 100-500nm thickness, e.g. SiO₂ of 290 nm. Layer 2: NbOx of 5-50 nm thickness, e.g. Nb₂O₅ of 7.5nm thickness. Layer 3: SiOx of 100-600 nm thickness, e.g. SiO₂ of 330 nm thickness. Layer 4: ITO 30-300 nm thickness (before patterning), e.g. of 145 nm, wherein an intermediate step is provided by ITO patterning, for example by photolithography resulting in locations, where the ITO is fully removed. The stack is laminated on top of the display, e.g. on top of the color filter glass or the polarizer of the color filter glass of an LCD or on top of the final outer glass of a display. This is achieved by using a transparent adhesive, e.g. an optical clear adhesive (OCA) or a lamination foil with a refractive index around 1.4 to 1.6, e.g. of 1.45 - 1.50 at the range between 380 and 780 nm. The performance of the final touch screen display (touch screen and display mounted together) is thereby improved.

According to another example, a layer stack or transparent body can be manufactured as follows, wherein improved visual invisibility, transmittance, and color fastness within the final TSP (touch screen panel)/display product and reduced electrical resistance can be provided. The layers are numbered as they are subsequently deposited on a substrate, e.g. a cover lens such as a glass having a thickness of 0.1 mm or above, e.g. 0.5 mm to 0.7 mm or of about 0.3 mm. Layer 1: NbOx of 3-15 nm thickness, e.g. Nb₂O₅ of 6.5nm thickness. Layer 2: SiOx of 30-100 nm thickness, e.g. SiO₂ of 46 nm thickness. Layer 3: NbOx of 5-20 nm thickness, e.g. Nb₂O₅ of 9 nm thickness. Layer 4: ITO 50-300 nm thickness (before patterning), e.g. of 107 nm, wherein an intermediate step is provided by ITO patterning, for example by photo-lithography resulting in locations, where the ITO is fully removed. The stack is laminated on top of the display, e.g. on top of the color filter glass or the polarizer of the color filter glass of an LCD or on top of the final outer glass of a display. This is achieved by using a transparent adhesive, e.g. an optical clear adhesive (OCA) or a lamination foil with a refractive index around 1.4 to 1.6, e.g. of 1.45 - 1.50 at the range between 380 and 780 nm. The performance of the final touch screen display (touch screen and display mounted together) is thereby improved.

According to another example, a layer stack or transparent body can be manufactured as follows, wherein improved visual invisibility, transmittance, and color fastness within the final TSP (touch screen panel)/display product and reduced electrical resistance can be provided. The layers are numbered as they are subsequently deposited on a substrate, e.g. a cover lens such as a glass having a thickness of 0.1 mm or above, e.g. 0.5 mm to 0.7 mm or of about 0.3 mm. Layer 1: ITO 50-300 nm thickness (before patterning), e.g. of 103 nm, wherein an intermediate step is provided by ITO patterning, for example by photo-lithography resulting in locations, where the ITO is fully removed. Layer 2: NbOx of 5-20 nm thickness, e.g. Nb₂O₅ of 9nm thickness. Layer 3: SiOx of 30-100 nm thickness, e.g. SiO₂ of 46 nm thickness. Layer 4: NbOx of 3-15 nm thickness, e.g. Nb₂O₅ of 6.5 nm thickness. The stack is laminated on top of the display, e.g. on top of the color filter glass or the polarizer of the color filter glass of an LCD or on top of the final outer glass of a display. This is achieved by using a transparent adhesive, e.g. an optical clear adhesive (OCA) or a lamination foil with a refractive index around 1.4 to 1.6, e.g. of 1.45 - 1.50 at the range between 380 and 780 nm. The performance of the final touch screen display (touch screen and display mounted together) is thereby improved.

According to yet another example, a layer stack or transparent body can be manufactured as follows, wherein improved visual invisibility, transmittance, and color fastness within the final TSP (touch screen panel)/display product and reduced electrical resistance can be provided. The layers are numbered as they are subsequently deposited on a substrate, e.g. a cover lens such as a glass having a thickness of 0.1 mm or above, e.g. 0.5 mm to 0.7 mm or of about 0.3 mm. Layer 1: NbOx of 3-15 nm thickness, e.g. Nb₂O₅ of 6 nm thickness. Layer 2: SiOx of 30-100 nm thickness, e.g. SiO₂ of 46 nm thickness. Layer 3: NbOx of 5-20 nm thickness, e.g. Nb₂O₅ of 9 nm thickness. Layer 4: ITO 50-300 nm thickness (before patterning), e.g. of 101 nm, wherein an intermediate step is provided by ITO patterning, for example by photo-lithography resulting in locations, where the ITO is fully removed. Layer 5: SiOx of 150-300 nm thickness, e.g. SiO₂ of 170 nm thickness. The stack is laminated on top of the display, e.g. on top of the color filter glass or the polarizer of the color filter glass of an LCD or on top of the final outer glass of a display. This is achieved by using a transparent adhesive, e.g. an optical clear adhesive (OCA) or a lamination foil with a refractive index around 1.4 to 1.6, e.g. of 1.45 - 1.50 at the range between 380 and 780 nm. The performance of the final touch screen display (touch screen and display mounted together) is thereby improved.

For example, the ITO thickness used for a touch sensor provides for very low sheet resistance of 20 Ohm/sq or below, or even 15 Ohm/sq. Typical visual reflectance of such mounted touch screen display can be described by y* < 6% or even y* < 5.5 %, the difference between areas without ITO and with 145 nm ITO being less than <0.2 or even less than <0.1 %. The color value of this system can be a*, b* being as an absolute value approximately 1.0 or below or even 0.3 or below, the difference between areas without ITO and with 145 nm ITO being less than <0.3. The transmittance values for the light originating from the display behind the touch screen reaching the viewer also exhibit very good values: |a*| & |b*| < 0.5, (a*, b*, wherein color differences between areas with ITO and without ITO being < 0.5), visual transmittance can be Y*> 93%, or even Y*> 95%, wherein the Y*-difference between areas with ITO and without ITO being < 3%. Typically these stacks with thick patterned ITO, dielectric layers and a clear adhesive, are such that the stack and the integration design provides also for ITO pattern invisibility up to a viewing range of 140° (+/- 70° to the perpendicular, regular viewing direction) while within this range the visual reflectance is always below 3%. The color difference between areas with and without ITO is visually negligible for a viewing range up to 60° with negative a* and b* values and |a*| and |b*| still being less than 2.

According to typical embodiments, which can be combined with other embodiments described herein, the first dielectric film being deposited on the substrate can typical be a high refractive index layer, e.g. with a refractive index of of at least 1.8 For example, a niobium-oxide containing film can be deposited as the first dielectric film on the substrate.

According to yet further embodiments, which can be combined with other embodiments described herein, a TCO thickness of below 145 nm, e.g. of 30 nm to 130 nm, such as 75 nm, will result in even better optical performance and invisibility characteristics as the above described values.

According to yet further typical embodiments, the dielectric films 16, 18 and 20 can be layers including oxides, nitrides or oxinitrides, wherein the respective oxide, nitride or oxinitride includes at least 70 weight-%, typically at least 90 weight-% of the respective oxide-compound, nitride-compound, or oxinitride-compound. Thereby, either a layer structure for high transparency or a layer structure with improved transmission characteristics, as described below, can be provided.

More specifically, according to embodiments herein, the first, optionally a third dielectric film, or further dielectric films, can be a film, e.g. consisting of SiO2, have a lower refractive index than the second dielectric film, e.g. consisting of Nb₂O₅, Si3N4 or the like. However, starting with a low refractive index film might be a beneficial option for some specific cases only. As described above, typically, the first dielectric layer provided onto a substrate would have a high refractive index. A first transparent layer stack of a transparent body, e.g. a three-layer-type stack, manufactured according to embodiments herein provides, in view of the additional dielectric films in comparison to at least some known transparent bodies for use in a touch panel and the characteristic combination of films with different refractive indexes, a barrier that facilitates a proper transmission of light through the transparent body. According to typical embodiments, which can be combined with other embodiments described herein, dielectric films with lower refractive index, for example lower than 1.50 or, more specifically, lower than 1.47 or, even more specifically, lower than 1.45 and dielectric films with higher refractive index, for example of at least 1.80 or, more specifically, at least 2.10, or, even more specifically, at least 2.40 are provided in an alternating manner. Thereby, films having lower refractive indexes can be provided by films containing SiOx, MgFx, SiOxNy, or the like. For example, films having a higher refractive index can be provided by films containing NbOx, SiNx, SiOxNy, AlOx, AlOxNy, TiOx TaOx, or the like.

According to embodiments described herein, transparent body 10 includes a transparent conductive film 22, such as, but not limited to, indium tin oxide (ITO), in particular, crystalline ITO or ITO with a sheet resistance of 100 Ohm/square and below. According to different embodiments, which can be combined with other embodiments described herein, typically, ITO with composition 97% In203 and 3% SnO2 for crystalline ITO and/or ITO with composition 90% In2O3 and 10% SnO2 for non-crystalline ITO can be used.

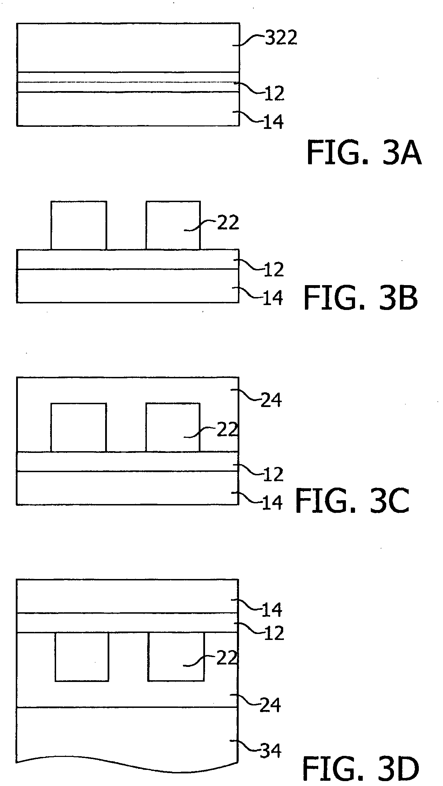

Figure 3 illustrates manufacturing of a transparent layer stack or transparent body, which can be used, for example, for a touch panel display. As shown in figure 3A, the layer stack 12 is provided over the transparent substrate 14. According to different embodiments, the transparent substrate can be a flexible substrate or a rigid substrate, an organic substrate or an inorganic substrate, can be a glass or a foil, and can have other characteristics like being linearly or circular polarizing, a lambda quarter retarder or non-polarizing. Typically, the transparent substrate can have a high degree of transparency in the visible range of 380 nm to 780 nm.

According to yet further examples, the transparent substrate 14 can include glass (flexible or rigid), plastic (flexible or rigid), which can further be already covered with thin film layers, a hard coat or lacquer, a linear or circular polarizer material, or lambda quarter retarder. Particularly for glass substrates, deposition processes and manufacturing methods on the glass substrate can be provided at higher temperatures as compared to plastic substrates. For example temperatures of 150°C or above or even temperatures of 200°C or above, such as 300 °C, can be utilized for manufacturing of transparent bodies for the touch panel display on glass substrates.

According to yet further embodiments, which can be combined with other embodiments described herein, the layer stack 12 is typically an index matching layer stack having at least a first and a second dielectric film, wherein the first refractive index is provided by the first dielectric film and the second refractive index is provided by the second dielectric film, and wherein the second refractive index is different from the first refractive index. According to an exemplary implementation, which can be combined with other embodiments described herein, a first dielectric film, a second dielectric film and a plurality of further dielectric films can be deposited such that a continuous or quasi-continuous (e.g. step-like with small steps) change in refractive index can be generated in the transparent layer stack 12. This may also be referred to as one dielectric layer with a gradient in refractive index. According to typical implementations, the dielectric films can be manufactured by chemical vapor deposition or physical vapor deposition, for example sputtering or evaporation. Typical examples can be insulating materials with high and low refractive indexes, for example SiOx, TiOx, NbOx, SiNx, SiOxNy, AlOx, AlOxNy, TaOx, and combinations thereof.

As shown in figure 3A a transparent conductive oxide layer 322 is deposited over the layer stack 12. According to embodiments described herein, the transparent conductive layer stack has increased conductivity by providing an increased layer thickness or a decreased specific resistance of the layer material. Thereby, for example, TCO layer thicknesses of 40 nm and above, e.g. 50 nm to 150 nm can be utilized.

According to yet further embodiments, which can be combined with other embodiments described herein, the transparent conductive oxide layer can also be provided as a transparent conductive oxide layer stack having one or more transparent conductive oxide films. During manufacturing, the transparent conductive oxide film or transparent conductive film stack can be heated during or after deposition, for example by thermal heating or by RTP flashlights. Typically, the transparent conductive oxide can be heated to temperatures of 80°C or above. The manufacturing of the transparent conductive oxide films can be provided by chemical vapor deposition or physical vapor deposition, e.g. sputtering or evaporation. In order to provide a high yield of manufacturing, for example DC sputtering of a transparent conductive oxide layer from a rotatable target can be provided. Typical examples of the transparent conductive oxide or the transparent conductive oxide (TCO) layer stack can be ITO, doped ITO, impurity-doped ZnO, In₂O₃, SnO₂ and CdO, ITO (In2O3:Sn), AZO (ZnO:Al), IZO (ZnO: In), GZO (ZnO:Ga), multi-component oxides including or consisting of combinations of ZnO, In₂O₃ and SnO₂, a layer stack from at least an ITO layer and a metal layer, e.g. an ITO/metal/ITO-stack or a metal/ITO/metal-stack.

As shown in figure 3B, the transparent conductive oxide layer 322 (see figure 3A) is structured to provide a structured transparent conductive oxide layer 22. The structured TCO layer can be provided by depositing a TCO layer and patterning the TCO layer in order to provide a structured TCO layer. Further, a mask and/or a photoresist can be provided to deposit the structured TCO layer.

Figures 3C and 3D illustrate a transparent adhesive 24, such as an optically clear adhesive in order to provide invisibility of the structured transparent conductive oxide layer 22 together with the transparent layer stack 12, when the transparent body is bonded to the display 34. According to different embodiments, the transparent adhesive can be an optical clear adhesive laminate or liquid optical clear adhesive with a refractive index close to a second substrate or polarizer, i.e. the substrate or polarizer of the display 34. For example, the refractive index can be close to the refractive index of glass (1.48) or of PMMA (1.6), for example, in the range between 1.48 and 1.6. According to yet further embodiments, the transparent adhesive can have a visual transmittance of 95% or above, 97% or above, or even 99% or above, and/or a low haze, e.g. of 3 % or below, of 2 % or below, or even of 1 % or below.

According to embodiments described herein, a structured TCO layer, e.g. an ITO layer, an index matching layer and a transparent adhesive configured for bonding to a display, a color filter, an electro-optical device, or the like, is provided such that the index matching layer and the transparent adhesive provide essentially invisibility of the structures of the TCO. Accordingly, the layer stack or transparent body, for example a touch panel layer stack, can be bonded to or integrated in a display device with improved visual and electrical characteristics.

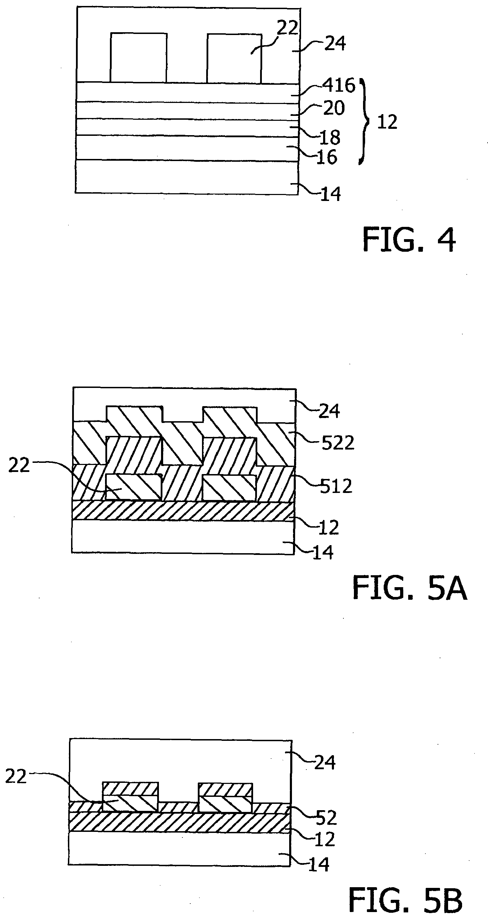

Figure 4 illustrates yet further embodiments, which can be combined with other embodiments described herein. As shown in figure 4, the substrate of the transparent body, which can for example be used in a touch panel, is provided. The substrate can be, for example, the cover lens after the transparent touch body is bonded to an electro-optical device, such as a display or the like. The embodiments described with respect to figure 4 include four dielectric films 16, 18, 20 and 416, which form a transparent layer stack. On top of the transparent layer stack, the structured transparent conductive film 22 is provided. According to typical embodiments, which can be combined with other embodiments described herein, the transparent conductive oxide film can be TCO layer, which is deposited by DC sputtering from a rotatable target. However, other position techniques might be applied as well. Sputtering from a rotatable target is, for example useful for manufacturing of large area devices.

According to some embodiments, large area substrates or respective carriers, wherein the carriers have a plurality of substrates, may have a size of at least 0.174 m². Typically, the size can be about 0.67m² (0.73x0.92m - Gen 4.5) to about 8 m², more typically about 2 m² to about 9 m² or even up to 12 m². Typically, the substrates or carriers, for which the structures, apparatuses, such as cathode assemblies, and methods according to embodiments described herein are provided, are large area substrates as described herein. For instance, a large area substrate or carrier can be GEN 4.5, which corresponds to about 0.67 m2 substrates (0.73x0.92m), GEN 5, which corresponds to about 1.4 m² substrates (1.1 m x 1.3 m), GEN 7.5, which corresponds to about 4.29 m² substrates (1.95 m x 2.2 m), GEN 8.5, which corresponds to about 5.7m² substrates (2.2 m x 2.5 m), or even GEN 10, which corresponds to about 8.7 m² substrates (2.85 m × 3.05 m). Even larger generations such as GEN 11 and GEN 12 and corresponding substrate areas can similarly be implemented.

The index matching layer stack 12, as shown in figure 4, together with the transparent adhesive 24 for bonding of the transparent body to a display or the like results in improved optical characteristics. The structures of the TCO layer are essentially invisible to the user of such a device due to the transparent layer stack and the transparent adhesive. According to embodiments described herein, this can be provided for the transparent conductive films having a sheet resistance of 100 Ohm/square or below, for example transparent conductive oxide layers of 40 nm or above, or even 100 nm or above.

According to different embodiments, which can be combined with other embodiments described herein, two or more dielectric layers can be provided in the transparent layer stack 12.

According to yet further embodiments, the two or more layers can be a plurality of dielectric layers or films, for example, such that a gradient in the refractive index in the layer stack is provided. For example, a first dielectric film can be provided with a first refractive index and the refractive index can be changed during further deposition of the transparent layer stack. The change can be continuous or step-like. Accordingly further dielectric films (16-20; 416) can be provided, wherein a refractive index can be obtained in the transparent layer stack. Thereby, for example SiOxNy can be deposited wherein the amount of oxygen and nitrogen is continuously or step-wise changed from y=1 to y = 0 and from x = 0 to x = 2 or vice versa.

As described above, according to some embodiments described herein, the films in the transparent layer stack, which acts as an index matching layer stack, and the transparent conductive adhesive are provided with refractive indices, respectively, such that the patterning of the structured TCO layer or the structure layer stack including a TCO layer appears essentially invisible for a user of an opto-electronic device, e.g. a touch panel. However, according to yet further embodiments, which can be combined with other embodiments described herein, an index matching functionality of the transparent adhesive can also be provided by a further dielectric film, which is provided between the transparent conductive film and the transparent adhesive. According to typical implementations thereof, the further dielectric layer provided onto the transparent conductive film, e.g. in direct contact with the transparent conductive film, can be a dielectric film with a low refractive index. For example, the refractive index can be 1.5 or below. According to yet further optional modifications of such embodiments, one or more further dielectric films can be deposited over the transparent conductive film. Typically, the one or more dielectric films can be selected from the group consisting of: SiOx, TiOx, NbOx, SiNx, SiOxNy, AlOx, AlOxNy, TaOx, and combinations thereof. Accordingly, processes described herein may include one or more further deposition steps of such layers and apparatuses for manufacturing may include one or more further deposition assemblies for depositing such layers.

According to yet further embodiments, which can be combined with other embodiments described herein, the combination of the transparent layer stack 12 and the transparent conductive film can be repeated twice, three times or even four times. For each of the transparent conductive films, the pattern structure and/or pattern direction can be different as compared to another structured TCO layer. Further, an unpatterned or unstructured TCO layer can be utilized for index matching purposes or the like. FIG. 5A shows a transparent layer stack 12 deposited over the substrate 14. The structured transparent conductive film 22 is provided on the transparent layer stack 12. Thereafter, a further transparent layer stack 512, for example an index matching layer stack including one, two, or more dielectric films are deposited. Therein, different refractive indices are provided for adjacent films. The second transparent conductive film 522 is provided over the second transparent layer stack 512. The cross-section illustrated in FIG. 5A does not show a structuring of the second transparent conductive film 522. However, the structuring can be applied in the direction different from the paper plane. The transparent adhesive 24 is provided on the transparent conductive film 522 and is configured for bonding the transparent body to the electro-optical device, such a display or the like.

According to yet further embodiments, which can be combined with other embodiments described herein, the combination of the transparent layer stack 12 and the transparent conductive film can be further supported by another dielectric layer 52. Further, an unpatterned or unstructured TCO layer can be utilized for index matching purposes or the like. FIG. 5B shows a transparent layer stack 12 deposited over the substrate 14. The structured transparent conductive film 22 is provided on the transparent layer stack 12. Thereafter, a further dielectric layer 52, for example an index matching layer is deposited. Therein, different refractive indices are provided for adjacent films. Thereby, it is possible to use transparent adhesives, which are not necessary for index matching or which are less relevant for index matching such that the number of choices of adhesives can be increased.

According to certain embodiments, the first transparent layer stack, the transparent conductive film, and the transparent adhesive are deposited in a manner such that the a* and b* value for the manufactured transparent body is below 1.5 or, in particular 1, or more specifically, 0.7, or, even more specifically, 0.2. In particular, according to embodiments herein, the a* and b* value for the structure formed solely by the first transparent layer stack, the transparent conductive film, and the transparent adhesive, and placed above a substantially transparent substrate may adopt these values.

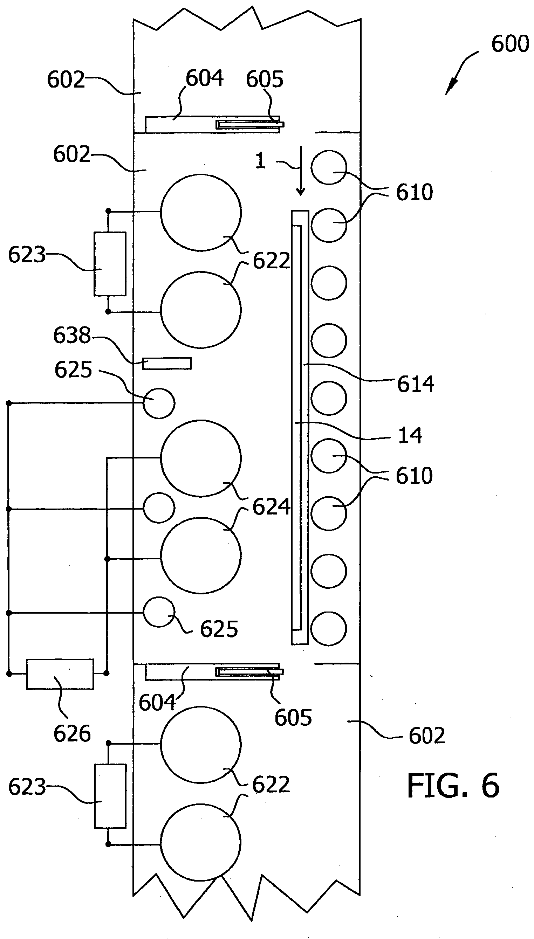

Figure 6 shows a deposition apparatus 600. Exemplarily, one vacuum chamber 602 for deposition of layers therein is shown. As indicated in figure 6, further chambers can be provided adjacent to the chamber 602. The vacuum chamber 602 can be separated from adjacent chambers by a valve having a valve housing 604 and the valve unit 605. Thereby, after the carrier 614 with the substrate 14 thereon is, as indicated by arrow 1, inserted in the vacuum chamber 602, the valve unit 605 can be closed. Accordingly, the atmosphere in the vacuum chambers can be individually controlled by generating a technical vacuum, for example with vacuum pumps connected to the chamber 602, and/or by inserting process gases in the deposition region in the chamber.

According to typical embodiments, process gases can include inert gases such as argon and/or reactive gases such as oxygen, nitrogen, Hydrogen (H2) and ammonia (NH3), Ozone (03), activated gases or the like. Within the chamber 602, rollers 610 are provided in order to transport the carrier 614 having the substrate 14 thereon into and out of the chamber 602.

Within the chamber 602, two different groups of deposition sources (cathodes 622 and 624) are illustrated in FIG. 6. As described in more detail below, the groups of deposition sources can typically be provided in different chambers in the event different deposition processes are provided by the groups of deposition sources.

The deposition sources can for example be rotatable cathodes having targets of the material to be deposited on the substrate. Typically, the cathodes can be rotatable cathodes with a magnetron therein. Thereby, magnetron sputtering can be conducted for depositing of the layers. Cathodes 622 are connected to an AC power supply 623 such that the cathodes can be biased in an alternating manner.

As used herein, "magnetron sputtering" refers to sputtering performed using a magnet assembly, that is, a unit capable of a generating a magnetic field. Typically, such a magnet assembly consists of a permanent magnet. This permanent magnet is typically arranged within a rotatable target or coupled to a planar target in a manner such that the free electrons are trapped within the generated magnetic field generated below the rotatable target surface. Such a magnet assembly may also be arranged coupled to a planar cathode.

Thereby, magnetron sputtering can be realized by a double magnetron cathode, i.e. cathodes 622, such as, but not limited to, a TwinMag™ cathode assembly. Particularly, for MF sputtering from a silicon target, target assemblies including double cathodes can be applied. According to typical embodiments, the cathodes in a deposition chamber may be interchangeable. Accordingly, the targets are changed after the silicon has been consumed.

According to typical embodiments, that dielectric layers can be deposited by sputtering, for example magnetron sputtering, of rotatable cathodes having an AC power supply. Typically, MF sputtering can be applied for depositing the dielectric layers. Thereby, according to typical embodiments, sputtering from a silicon target, e.g. a sprayed silicon target, is conducted by MF sputtering, that is middle frequency sputtering. According to embodiments herein, middle frequency is a frequency in the range 5 kHz to 100 kHz, for example, 10 kHz to 50 kHz.

Sputtering from a target for a transparent conductive oxide film is typically conducted as DC sputtering. The cathodes 624 are connected to the DC power supply 626 together with anodes 625 collecting electrons during sputtering. Thus, according to yet further embodiments, which can be combined with other embodiments described herein, the transparent conductive oxide layers, for example, the ITO layers can be sputtered by DC sputtering, i.e. an assembly having cathodes 624.

For simplicity, the upper cathodes 622 and the cathodes 624 are illustrated to be provided in one vacuum chamber 602. Typically, as exemplarily indicated by lower cathodes 622, the cathodes for depositing different layers are provided in different vacuum chamber, for example, the chamber 602 and the vacuum chambers adjacent to the vacuum chamber 602. This is particularly true as the dielectric layers, as described herein, which can be oxide-layers, nitrite-layers, or oxinitride-layers, can be deposited by a reactive deposition process where the target material reacts with oxygen and/or nitrogen after the material has been released from the target. By providing the groups of cathodes in different chambers, an atmosphere with an appropriate processing gas and/or the appropriate degree of technical vacuum can be provided in each deposition area.

According to yet further embodiments, depending on the number of dielectric layers deposited on the substrate 14, two or more groups of cathodes 622 can be provided in the deposition apparatus 600.

According to typical embodiments, deposition is performed by sputtering of one or more rotatable targets. More specifically, according to embodiments herein, at least one of the films referred to above is deposited by sputtering of a rotatable target, so that formation of a stable transparent body and with a high quality is facilitated. For example, according to embodiments herein, a film may be deposited having a higher uniformity, and with a low density of defects and contamination particles. Thereby, it is facilitated manufacturing of a high-quality transparent body that not only yields a proper transmission of light but also yields a stable performance over time. Furthermore, a manufacturing process including sputtering of one or more rotatable targets may further facilitate a higher manufacturing rate and the production of a lower number of contaminant particles as compared to other deposition methods.

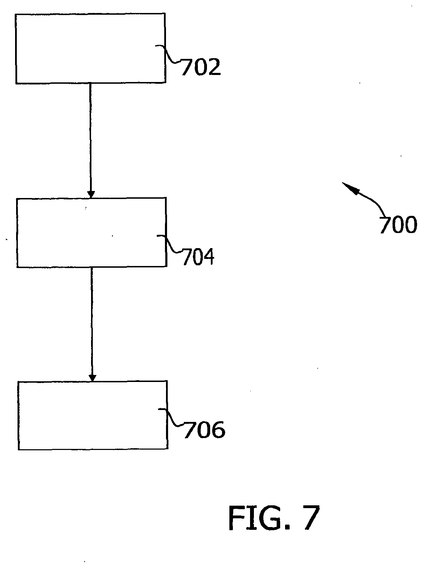

Figure 7 shows a flowchart illustrating a process 700 for manufacturing a transparent body as described herein. In step 702, the first transparent layer stack (e.g. layers stack 12) is deposited over the transparent substrate. Thereby, the layer stack includes at least two dielectric films, wherein the refractive indices of the dielectric films are different from each other and films with a higher refractive index and films with the lower refractive index can be deposited in an alternating manner. In step 704, the structured transparent conductive film, for example structured ITO layer, is deposited over the transparent layer stack 12. According to different implementations, which can be combined with other implementations described herein, the structured transparent conductive film can be also a stack of conductive films. For example, a TCO/metal/TCO-stack, for example, an ITO/metal/ITO-stack can be provided in step 704.

According to typical embodiments, which can be combined with other embodiments described herein, structuring procedures can be selected from the group consisting of: (1) laser scribing, (2) photo lithography, (3) printing adsorption barrier pattern (e.g. oil) followed by TCO deposition, (4) a lift-off process (formation of photo-resist pattern on substrate followed by TCO deposition and lift-off with photo-resist solvent), (5) film deposition using a shadow mask, or combinations thereof.

According to certain embodiments, one or some of the chambers may be configured for performing sputtering without a magnetron assembly. One or some chambers, for example additional chamber, may be configured for performing deposition by other methods, such as, but not limited to, chemical vapor deposition or pulsed laser deposition.

Invisible ITO solutions have extremely high demands on the optical uniformity of optical properties (color values in transmission and reflection). This corresponds technically to the deposition of uniform films with respect to film thickness and optical dispersion properties. Accordingly, the deposition apparatuses as described herein can further include a measurement system 638 configured for measuring during deposition optical properties of at least one of the films forming part of at least one of the first layer stack or the transparent conductive film.

Further, as described above, the dielectric films can be typically reactively sputtered. Accordingly, the first deposition assembly (622) can be configured for depositing the dielectric films by reactive sputtering. According to typical embodiments, Si-containing layers can be sputtered reactively, and/or Nb-containing layers or ITO-containing layers can be sputtered from a ceramic target.

According to certain embodiments, exemplary process 700 may further include a heating treatment of the substrate for degassing of the substrate prior to deposition. For example, the substrate may be heated at a temperature between 60 and 300 °C depending on the substrate speed. According to certain embodiments, exemplary process 700 may include performing a DC and/or medium frequency (MF) pre-treatment of the substrate with a power between 1 and 3 kW. Moreover, exemplary process 700 may include performing a pre-treatment of the substrate at an argon and/or oxygen atmosphere such as, for example, an oxygen rich pre-treatment. According to embodiments herein, medium frequency is a frequency in the range of 5 kHz to 100 kHz, for example, 30 kHz to 50 kHz.

The sputter coating sources in the exemplary deposition apparatuses or in an apparatus according to embodiments herein may be a DC-cathode with planar or rotatable targets (such as, but not limited to, ceramic ITO), and planar or rotatable targets (such as a doped silicon target, in particular sprayed Si targets for depositing SiO₂, or Si3N4, SiOxNy) or targets including a material to deposit one of the other dielectric layers disclosed herein.

As described herein, the transparent conductive film has a sheet resistance of 100 Ohm/square or below. This can be provided by providing a comparably thick transparent conductive layer and/or utilizing a TCO material with a low specific resistivity. This results in a more complex index-matching situation for reaching the required high optical performance such as pattern invisibility, color neutrality and high transmittance levels. Accordingly, in step 706 transparent adhesive, for example an optically clear adhesive, is provided in order to bond the transparent body to an electro-optical device, such as a display, a display of a mobile phone, a display of the touch panel TV, a display of the touch panel computer, or the like. Accordingly, as compared to bonding the transparent body providing the body having the touch panel functionality to the device with an air gap, an improved index matching for invisibility of the patterning of the transparent conductive film can be provided.

As described above, according to some embodiments, which can be combined with other embodiments described herein, the transparent body, i.e. the thin film stacks, are produced involving magnetron sputtering from rotary targets. Invisible ITO solutions have extremely high demands on the optical uniformity of optical properties (color values in transmission and reflection), which corresponds technically to the deposition of very uniform films with respect to film thickness and optical dispersion properties. Accordingly, longer targets than the targeted sputtering height can be utilized. Thereby, sputtering from rotary targets offers advantages regarding yield, material utilization, machine up time and finally production costs, while planar targets have re-deposition zones, which are responsible for enhanced arcing and particle generation, and hence need to be much longer than rotary targets to provide for particle-free and uniform films. According to yet further embodiments, which can be combined with other embodiments described herein, the vertical film uniformity, i.e. optical thickness of the film can be supported, e.g. by segmented gas introduction or corresponding measures.

## Claims

1. A process for manufacturing a transparent body (10) for use in a touch screen panel, the process comprising:
depositing a first transparent layer stack (12) over a transparent substrate (14), wherein said first transparent layer stack (12) is selected from the group consisting of:
a layer stack, wherein the layer stack includes a first dielectric film with a gradient refractive index from a first refractive index to a second refractive index, and
a layer stack, wherein the layer stack includes at least a first dielectric film (16) with a first refractive index and a second dielectric film (18) with a second refractive index different from the first refractive index;
providing a structured transparent conductive film (22) and wherein the structured transparent conductive film corresponds to a sheet resistance of 100 Ohm/square or below; and
providing a transparent adhesive over the structured transparent conductive film configured for attaching the transparent body to the adjacent components of the touch screen panel, wherein the transparent adhesive has a refractive index of 1.3 to 1.7.

2. The process according to claim 1, wherein the first transparent layer stack is deposited over the structured transparent conductive film or wherein the structured transparent conductive film is deposited onto the transparent substrate.

3. The process according to claim 1, wherein providing the structured transparent conductive film comprises patterning an unstructured deposited transparent conductive film.

4. The process according to claim 1, wherein the first dielectric film has a refractive index of at least 1.8 and the second dielectric film has a refractive index of 1.5 or below.

5. The process according to any of claims 1 to 4, wherein the first and second dielectric films are sputtered by MF sputtering, typically from a rotatable target, and the transparent conductive films are sputtered by DC sputtering, typically from a rotatable target.

6. A transparent body adapted for use in a touch screen panel comprising:
a transparent substrate;
a transparent layer stack deposited over the transparent substrate, wherein said transparent layer stack (12) is selected from the group consisting of:
a layer stack, wherein the layer stack includes a first dielectric film with a gradient refractive index from a first refractive index to a second refractive index different from the first refractive index, and
a layer stack, wherein the layer stack includes at least a first dielectric film (16) with a first refractive index and a second dielectric film (18) with a second refractive index different from the first refractive index;
a transparent conductive film deposited over the transparent substrate, wherein the structured transparent conductive film corresponds to a sheet resistance of 100 Ohm/square or below; and
a transparent adhesive deposited over the transparent conductive film and being configured for attaching the transparent body to the adjacent components of the touch screen panel, wherein the transparent adhesive has a refractive index of 1.3 to 1.7.

7. The transparent body according to claim 6, further comprising:
a second transparent substrate to which the transparent layer stack is to be attached, wherein the transparent adhesive has a refractive index similar to the refractive index of the second transparent substrate.

8. The transparent body according to claim 6, wherein the transparent substrate is selected from the group consisting of: a rigid substrate, a flexible substrate, an organic substrate, an inorganic substrate, a glass, a plastic foil, a polarizer material substrate, and a lambda quarter retarder substrate.

9. The transparent body according to any of claims 6 to 8, wherein the transparent layer stack is an index matching layer stack and/or is selected from the group consisting of: SiOₓ, SiNx, SiOₓN_{y}, AlOₓ, AlOₓN_{y}, TiOₓ, TaOx, MgFx and NbOₓ.

10. The transparent body according to any of claims 6 to 8, wherein the transparent conductive film has a thickness of 20 nm or above, particularly of 50 nm to 150 nm.

11. The transparent body according to any of claims 6 to 8, wherein the transparent conductive film includes indium tin oxide (ITO).

12. The transparent body according to any of claims 6 to 8, wherein the transparent adhesive is an optical clear adhesive laminate or a liquid optical clear adhesive.

13. A deposition apparatus (600) for manufacturing a transparent body (10) for use in a touch screen panel, said deposition apparatus comprising:
a first deposition assembly (622) configured to deposit a first transparent layer stack (12) over a substrate (14), said first transparent layer stack (12) including at least a first dielectric film (16) with a first refractive index, and a second dielectric film (18) with a second refractive index different from the first refractive index;
a second deposition assembly (624) configured to deposit a transparent conductive film (22); and
means for providing a transparent conductive adhesive over the structured transparent conductive film, wherein the transparent conductive adhesive has a refractive index of 1.3 to 1.7,
wherein said first deposition assembly (622) and said second deposition assembly (624) are arranged such that the first transparent layer stack (12) and the transparent conductive film (22) are disposed over the substrate (14) in this order, and wherein at least one of the first deposition assembly (622) or the second deposition assembly comprises a sputtering system operatively coupled to a target, said sputtering system being configured to deposit at least one of the first dielectric film (16), the second dielectric film (18), or the transparent conductive film (22) by sputtering of the target.

14. The deposition apparatus according to claim 13, wherein the first deposition assembly (622) and the second deposition assembly (624) are configured for depositing the first transparent layer stack (12) and the transparent conductive film (22) by magnetron sputtering, typically by magnetron sputtering from a rotatable target.

## Patentansprüche

1. Verfahren zum Herstellen eines transparenten Körpers (10) zur Verwendung in einem Touchscreen-Panel, wobei das Verfahren umfasst:
Aufbringen eines ersten transparenten Schichtstapels (12) über ein transparentes Substrat (14), wobei der erste transparente Schichtstapel (12) aus einer Gruppe ausgewählt wird, die umfasst:
einen Schichtstapel, wobei der Schichtstapel einen ersten dielektrischen Film mit einem Gradientenbrechungsindex von einem ersten Brechungsindex zu einem zweiten Brechungsindex enthält, und
einen Schichtstapel, wobei der Schichtstapel zumindest einen ersten dielektrischen Film (16) mit einem ersten Brechungsindex und einen zweiten dielektrischen Film (18) mit einem zweiten Brechungsindex, der sich von dem ersten Brechungsindex unterscheidet, enthält;
Bereitstellen eines strukturierten transparenten leitfähigen Films (22) und wobei der strukturierte transparente leitfähige Film einem Flächenwiderstand von 100 Ohm/Quadrat oder darunter entspricht; und
Bereitstellen eines transparenten Klebstoffs über dem strukturierten transparenten leitfähigen Film, der dafür konfiguriert ist, den transparenten Körper an den benachbarten Komponenten des Touchscreen-Panels zu befestigen, wobei der transparente Klebstoff einen Brechungsindex von 1,3 bis 1,7 aufweist.

2. Verfahren nach Anspruch 1, wobei der erste transparente Schichtstapel über dem strukturierten transparenten leitfähigen Film aufgebracht wird oder wobei der strukturierte transparente leitfähige Film auf dem transparenten Substrat aufgebracht wird.

3. Verfahren nach Anspruch 1, wobei das Bereitstellen des strukturierten transparenten leitfähigen Films das Strukturieren eines unstrukturierten aufgebrachten transparenten leitfähigen Films umfasst.

4. Verfahren nach Anspruch 1, wobei der erste dielektrische Film einen Brechungsindex von mindestens 1,8 aufweist und der zweite dielektrische Film einen Brechungsindex von 1,5 oder darunter.

5. Verfahren nach einem der Ansprüche 1 bis 4, wobei die ersten und zweiten dielektrischen Filme durch MF-Zerstäubung gesprüht werden, typischerweise von einem drehbaren Ziel, und die transparenten leitfähigen Filme durch DC-Zerstäubung gesprüht werden, typischerweise von einem drehbaren Ziel.

6. Transparenter Körper, der für die Verwendung in einem Touchscreen-Panel ausgelegt ist, umfassend: ein transparentes Substrat;
einen transparenten Schichtstapel, der über dem transparenten Substrat aufgebracht ist, wobei der transparente Schichtstapel (12) aus einer Gruppe ausgewählt wird, die umfasst:
einen Schichtstapel, wobei der Schichtstapel einen ersten dielektrischen Film mit einem Gradientenbrechungsindex von einem ersten Brechungsindex zu einem zweiten Brechungsindex, der sich von dem ersten Brechungsindex unterscheidet, enthält, und
einen Schichtstapel, wobei der Schichtstapel zumindest einen ersten dielektrischen Film (16) mit einem ersten Brechungsindex und einen zweiten dielektrischen Film (18) mit einem zweiten Brechungsindex, der sich von dem ersten Brechungsindex unterscheidet, enthält;
einen transparenten leitfähigen Film, der über dem transparenten Substrat aufgetragen ist, wobei der strukturierte transparente leitfähige Film einem Flächenwiderstand von 100 Ohm/Quadrat oder darunter entspricht; und
einen transparenten Klebstoff, der über dem transparenten, leitfähigen Film aufgebracht ist und der dafür konfiguriert ist, den transparenten Körper an den benachbarten Komponenten des Touchscreen-Panels zu befestigen, wobei der transparente Klebstoff einen Brechungsindex von 1,3 bis 1,7 aufweist.

7. Transparenter Körper nach Anspruch 6, ferner umfassend:
ein zweites transparentes Substrat, an dem der transparente Schichtstapel zu befestigen ist, wobei der transparente Klebstoff einen Brechungsindex aufweist, der dem Brechungsindex des zweiten transparenten Substrats ähnlich ist.

8. Transparenter Körper nach Anspruch 6, wobei das transparente Substrat aus der Gruppe ausgewählt wird, die besteht aus: einem starren Substrat, einem flexiblen Substrat, einem organischen Substrat, einem anorganischen Substrat, einem Glas, einer Kunststofffolie, einem Polarisatormaterialsubstrat und einem Lambda-Viertel-Verzögerer-Substrat.

9. Transparenter Körper nach einem der Ansprüche 6 bis 8, wobei der transparente Schichtstapel ein Indexanpassungsschichtstapel ist und/oder aus der Gruppe ausgewählt wird, die besteht aus: SiOₓ, SiNx, SiOₓN_{y}, AlOₓ, AlOₓN_{y}, TiOₓ, TaOx, MgFx und NbOₓ.

10. Transparenter Körper nach einem der Ansprüche 6 bis 8, wobei der transparente leitfähige Film eine Dicke von 20 nm oder darüber aufweist, insbesondere von 50 nm bis 150 nm.

11. Transparenter Körper nach einem der Ansprüche 6 bis 8, wobei der transparente leitfähige Film Indium-Zinnoxid (ITO) enthält.

12. Transparenter Körper nach einem der Ansprüche 6 bis 8, wobei der transparente Klebstoff ein optisch klares Klebstofflaminat oder ein flüssiger optisch klarer Klebstoff ist.

13. Aufbringungsvorrichtung (600) zum Herstellen eines transparenten Körpers (10) zur Verwendung in einem Touchscreen-Panel, wobei die Aufbringungsvorrichtung umfasst:
eine erste Aufbringungsanordnung (662), die dafür konfiguriert ist, einen ersten transparenten Schichtstapel (12) über einem Substrat (14) aufzubringen, wobei der erste transparente Schichtstapel (12) mindestens einen ersten dielektrischen Film (16) mit einem ersten Brechungsindex enthält, und einen zweiten dielektrischen Film (18) mit einem zweiten Brechungsindex, der sich von dem ersten Brechungsindex unterscheidet;
eine zweite Aufbringungsanordnung (624), die dafür konfiguriert ist, einen transparenten leitfähigen Film (22) aufzubringen; und
Mittel zum Bereitstellen eines transparenten leitfähigen Klebstoffs über dem strukturierten transparenten leitfähigen Film, wobei der transparente leitfähige Klebstoff einen Brechungsindex von 1,3 bis 1,7 aufweist,
wobei die erste Aufbringungsanordnung (622) und die zweite Aufbringungsanordnung (624) derart angeordnet sind, dass der erste transparente Schichtstapel (12) und der transparente leitfähige Film (22) über dem Substrat (14) in dieser Reihenfolge angeordnet sind, und wobei die erste Aufbringungsanordnung (622) und/oder die zweite Aufbringungsanordnung ein Zerstäubungssystem umfassen, das operativ mit einem Ziel gekoppelt ist, wobei das Zerstäubungssystem dafür konfiguriert ist, den ersten dielektrischen Film (16), den zweiten dielektrischen Film (18) und/oder den transparenten leitfähigen Film (22) durch Zerstäuben des Ziels aufzubringen.

14. Aufbringungsvorrichtung nach Anspruch 13, wobei die erste Aufbringungsvorrichtung (622) und die zweite Aufbringungsvorrichtung (624) für das Aufbringen des ersten transparenten Schichtstapels (12) und des transparenten leitfähigen Films (22) durch Magnetron-Zerstäubung konfiguriert sind, typischerweise durch Magnetron-Zerstäubung von einem drehbaren Ziel.

## Revendications

1. Processus de fabrication d'un corps transparent (10) à utiliser dans un panneau d'écran tactile, le processus comprenant de :
déposer une première pile de couches transparentes (12) sur un substrat transparent (14), dans lequel ladite première pile de couches transparentes (12) est sélectionnée dans le groupe comprenant :
une pile de couches, dans lequel la pile de couches inclut un premier film diélectrique avec un indice de réfraction à gradient allant d'un premier indice de réfraction à un second indice de réfraction, et
une pile de couches, dans lequel la pile de couches inclut au moins un premier film diélectrique (16) avec un premier indice de réfraction et un second film diélectrique (18) avec un second indice de réfraction différent du premier indice de réfraction ;
fournir un film conducteur transparent structuré (22) et dans lequel le film conducteur transparent structuré correspond à une résistance de couche de 100 ohm/carré ou inférieure ; et
fournir un adhésif transparent sur le film conducteur transparent structuré configuré pour fixer le corps transparent aux composants adjacents du panneau d'écran tactile, dans lequel l'adhésif transparent a un indice de réfraction de 1.3 à 1.7.

2. Processus selon la revendication 1, dans lequel la première pile de couches transparentes est déposée sur le film conducteur transparent structuré ou dans lequel le film conducteur transparent structuré est déposé sur le substrat transparent.

3. Processus selon la revendication 1, dans lequel fournir le film conducteur transparent structuré comprend la structuration d'un film conducteur transparent déposé non structuré.

4. Processus selon la revendication 1, dans lequel le premier film diélectrique a un indice de réfraction d'au moins 1.8 et le second film diélectrique a un indice de réfraction de 1.5 ou inférieur.

5. Processus selon une quelconque des revendications 1 à 4, dans lequel le premier et le second films diélectriques sont pulvérisés par pulvérisation MF, typiquement à partir d'une cible rotative, et les films conducteurs transparents sont pulvérisés par pulvérisation DC, typiquement à partir d'une cible rotative.

6. Corps transparent adapté à une utilisation dans un panneau d'écran tactile, comprenant :
un substrat transparent ;
une pile de couches transparentes déposée sur le substrat transparent, dans lequel ladite pile de couches transparentes (12) est sélectionnée dans le groupe composé de :
une pile de couches, dans lequel la pile de couches inclut un premier film diélectrique avec un indice de réfraction à gradient allant d'un premier indice de réfraction à un second indice de réfraction différent du premier indice de réfraction, et
une pile de couches, dans lequel la pile de couches inclut au moins un film diélectrique (16) avec un premier indice de réfraction et un second film diélectrique (18) avec un second indice de réfraction différent du premier indice de réfraction ;
un film conducteur transparent déposé sur le substrat transparent, dans lequel le film conducteur transparent structuré correspond à une résistance de couche de 100 ohm/carré ou inférieure ; et
un adhésif transparent déposé sur le film conducteur transparent et étant configuré pour fixer le corps transparent aux composants adjacents du panneau d'écran tactile, dans lequel l'adhésif transparent a un indice de réfraction de 1.3 à 1.7.

7. Corps transparent selon la revendication 6, comprenant en outre :
un second substrat transparent auquel la pile de couches transparentes doit être fixée, dans lequel l'adhésif transparent a un indice de réfraction similaire à l'indice de réfraction du second substrat transparent.

8. Corps transparent selon la revendication 6, dans lequel le substrat transparent est sélectionné dans le groupe composé de : un substrat rigide, un substrat flexible, un substrat organique, un substrat inorganique, un verre, un film plastique, un substrat de matériau polarisateur et un substrat retardateur à quart lambda.

9. Corps transparent selon une quelconque des revendications 6 à 8, dans lequel la pile de couches transparentes est une pile de couches à index concordant et/ou est sélectionnée parmi le groupe composé de : SiOₓ, SiNx, SiOₓN_{y}, AlOₓ, AlOₓN_{y}, TiOₓ, TaOx, MgFx et NbOₓ.

10. Corps transparent selon une quelconque des revendications 6 à 8, dans lequel le film conducteur transparent a une épaisseur de 20 nm ou supérieur, notamment de 50 nm à 150 nm.

11. Corps transparent selon une quelconque des revendications 6 à 8, dans lequel le film conducteur transparent inclut un oxyde d'étain et d'indium (ITO).

12. Corps transparent selon une quelconque des revendications 6 à 8, dans lequel l'adhésif transparent est un complexe adhésif optiquement clair ou adhésif liquide optiquement clair.

13. Dispositif de dépôt (600) pour fabriquer un corps transparent (10) à utiliser dans un panneau d'écran tactile, ledit dispositif de dépôt comprenant :
un premier ensemble de dépôt (622) configuré pour déposer une première pile de couches transparentes (12) sur un substrat (14), ladite première pile de couches transparentes (12) incluant au moins un premier film diélectrique (16) avec un premier indice de réfraction, et un second film diélectrique (18) avec un second indice de réfraction différent du premier indice de réfraction ;
un second ensemble de dépôt (624) configuré pour déposer un film conducteur transparent (22) ; et un moyen pour fournir un adhésif conducteur transparent sur le film conducteur transparent structuré, dans lequel l'adhésif transparent a un indice de réfraction de 1.3 à 1.7,
dans lequel ledit premier ensemble de dépôt (622) et ledit second ensemble de dépôt (624) sont agencés de sorte que la première pile de couches transparentes (12) et le film conducteur transparent (22) sont disposés sur le substrat (14) dans cet ordre, et dans lequel au moins un du premier ensemble de dépôt (622) ou du second ensemble de dépôt comprend un système de pulvérisation couplé opérationnellement à une cible, ledit système de pulvérisation étant configuré pour déposer au moins un du premier film diélectrique (16), second film diélectrique (16) ou film conducteur transparent (22) par pulvérisation de la cible.

14. Dispositif de dépôt selon la revendication 13, dans lequel le premier ensemble de dépôt (622) et le second ensemble de dépôt (624) sont configurés pour déposer la première pile de couches transparentes (12) et le film conducteur transparent (22) par pulvérisation au magnétron, typiquement par pulvérisation au magnétron à partir d'une cible rotative.
